Europäisches Patentamt

European Patent Office

Office européen des brevets

(11) Numéro de publication: **0 242 304 B1**

# FASCICULE DE BREVET EUROPEEN

(45) Date de publication de fascicule du brevet:
**27.11.91**

(51) Int. Cl.⁵: **H03F 3/50**

(21) Numéro de dépôt: 87400889.9

(22) Date de dépôt: **17.04.87**

(54) **Amplificateur suiveur à grande vitesse.**

(30) Priorité: **18.04.86 FR 8605646**

(43) Date de publication de la demande:
**21.10.87 Bulletin 87/43**

(45) Mention de la délivrance du brevet:
**27.11.91 Bulletin 91/48**

(84) Etats contractants désignés:
**DE FR GB IT NL**

(56) Documents cités:
**EP-A- 0 161 067**
**US-A- 4 484 147**

**IBM TECHNICAL DISCLOSURE BULLETIN, vol.
28, no. 6, novembre 1985, pages 2682-2683,
New York, US; "Balancing emitter follower"**

**R.C.A. TECHNICAL NOTES, TN no. 938, 17
septembre 1973, pages 1-7, R.C.A., Princeton, New Jersey, US; A.A.A. AHMED:
"Zero-offset potential follower circuits"**

(73) Titulaire: **THOMSON-CSF**
**51, Esplanade du Général de Gaulle**
**F-92800 Puteaux(FR)**

(72) Inventeur: **Lietar, Loic**
**THOMSON-CSF SCPI 19, avenue de Messine**
**F-75008 Paris(FR)**

(74) Mandataire: **de Beaumont, Michel**
**1bis, rue Champollion**
**F-38000 Grenoble(FR)**

Rank Xerox (UK) Business Services

## Description

La présente invention concerne les amplificateurs suiveurs de tension, qui sont des amplificateurs à gain unitaire à forte impédance d'entrée et à faible impédance de sortie, capables de fournir un courant de sortie élevé pour attaquer des charges capacitives importantes.

Les qualités exigés pour ce type d'amplificateur sont une bande passante élevée, une bonne linéarité de gain en fonctionnement statique (la tension de sortie doit suivre exactement la tension d'entrée), et une grande vitesse de réaction en présence d'une variation de signal d'entrée. Cette vitesse de réaction est souvent appelée "slew-rate" en anglais ; elle traduit la pente maximale de variation du signal d'entrée qui peut être retransmise sans distorsion à la sortie.

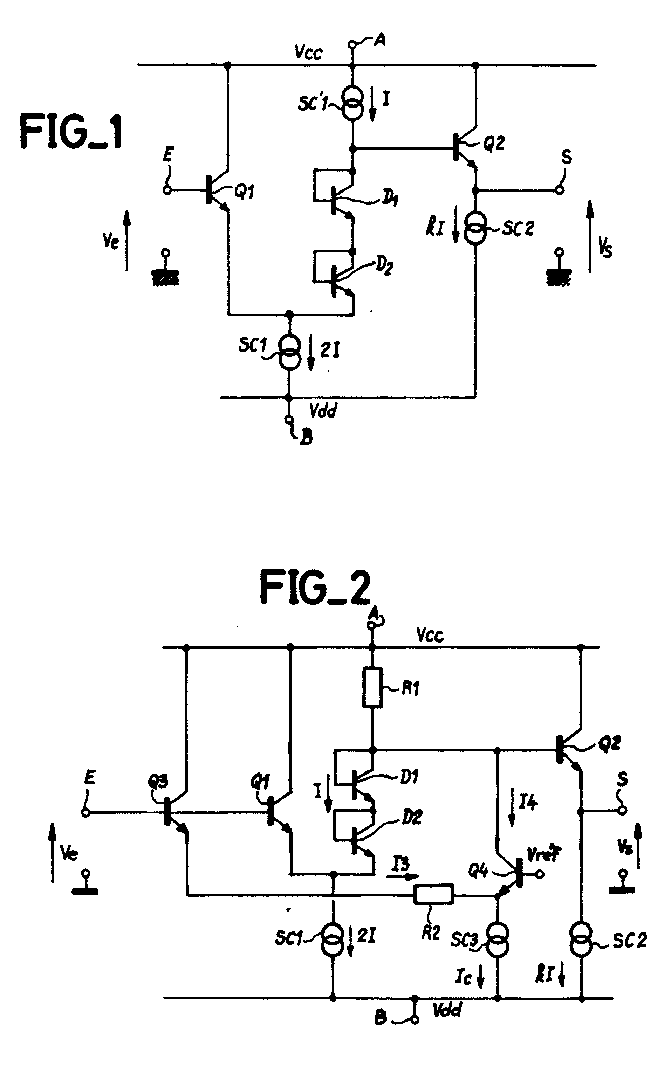

Un schéma classique d'amplificateur de la famille décrite dans RAC Technical Notes TN N° 938 17 Septembre 1973, pages 1-7, est représenté à la figure 1.

Entre deux bornes d'alimentation A et B, l'une à un potentiel haut Vcc et l'autre à un potentiel bas Vdd, sont connectés d'une part un étage d'entrée et d'autre part un étage de sortie.

L'étage d'entrée comprend deux branches en parallèle alimentées par une première source de courant SC1 reliée au potentiel bas Vdd. La première branche comprend un transistor Q1 (collecteur relié au potentiel haut Vcc, émetteur relié à la source de courant SCI) dont la base constitue l'entrée E de l'amplificateur.

La deuxième branche de l'étage d'entrée comprend une deuxième source de courant SC'1, reliée au potentiel haut Vcc, en série avec un ensemble de deux diodes D1, D2 polarisées dans le sens direct, les diodes étant réalisées sous forme de jonctions émetteur/base de transistors ayant leur collecteur relié à leur base.

L'étage de sortie comprend un deuxième transistor Q2 dont la base est reliée au point de jonction entre la deuxième source de courant SC'1 et le groupe de deux diodes en série. Le collecteur du deuxième transistor Q2 est relié au potentiel haut Vcc, son émetteur constitue la sortie S de l'amplificateur et il est relié à une autre source de courant SC2 reliée par ailleurs au potentiel bas Vdd.

La tension de sortie Vs (prise sur la sortie S par rapport à une masse à un potentiel de référence qui peut être intermédiaire entre Vcc et Vdd) suit la tension d'entrée Ve (prise sur l'entrée E par rapport à la même masse) dans les conditions suivantes:

On s'arrange, par le choix des dimensions des transistors et diodes, et par le choix des valeurs de courant imposées par les différentes sources de courant, pour que la somme des chutes de tension dans les diodes D1 et D2 soit toujours exactement égale à la somme des chutes de tension base-émetteur des deux transistors Q1 et Q2.

Alors, Vs reste exactement égale à Ve.

Par exemple, en admettant que le transistor Q2 ait une surface d'émetteur k fois plus grande que celle du transistor Q1, on choisit une valeur I pour la source de courant SC'1, une valeur 2I pour la source SC1, une valeur kI pour la source SC2, et une surface des diodes D1 et D2 égale à celle du transistor Q1 (les diodes D1 et D2 sont en fait des transistors dont la base est reliée au collecteur).

Dans ce cas, la tension de sortie Vs suit exactement la tension d'entrée Ve.

Le problème principal que l'on rencontre avec ce type d'amplificateur est la difficulté de réaliser la source de courant SC'1.

Les transistors Q1 et Q2 sont des transistors NPN plutôt que PNP, pour que la vitesse de réaction (slew-rate) de l'amplificateur soit la plus élevée possible. Alors, du fait que la source de courant SC'1 est reliée au potentiel haut Vcc, cette source de courant doit pratiquement être réalisée à partir d'un transistor PNP.

La présence de ce transistor PNP affecte défavorablement la vitesse de réaction intrinsèque de l'amplificateur.

La présente invention propose une construction d'amplificateur qui évite l'utilisation d'un transistor PNP et qui permet donc de maximiser la vitesse de réaction de l'amplificateur.

Selon l'invention, on remplace la source de courant SC'1 reliée au potentiel haut par une résistance. Mais comme cette résistance n'est pas équivalente à une source de courant, il en résulte une perturbation de fonctionnement telle que la tension de sortie Vs ne suit plus la tension d'entrée Ve. On prévoit donc en outre un circuit de compensation relié entre l'entrée E de l'amplificateur et le point de jonction entre la résistance et les diodes, pour dériver en ce point un courant variant en fonction du signal d'entrée de l'amplificateur, la variation de ce courant compensant exactement les variations de courant provoquées dans les diodes du fait du remplacement de la source de courant SC'1 par une résistance.

Autrement dit, lorsqu'il y avait une source de courant SC'1 en série avec les diodes, le courant dans les diodes ne variait pas malgré les variations de la tension d'entrée Ve. Avec une résistance, le courant dans les diodes se met à varier en fonction du signal d'entrée (il diminue lorsque la tension d'entrée augmente). Le circuit de compensation empêche cette variation en dérivant du point de jonction entre les diodes et la résistance un courant dont les variations sont justement les mêmes que celles qui sont induites dans la résistance. Les variations de courant dans la résistance se reportent donc entièrement dans la dérivation et laissent stable le courant dans les diodes.

Plus précisément, le circuit de compensation comprend deux branches alimentées par une troisième source de courant constant reliée à un potentiel bas, la première branche comprenant un troisième transistor dont la base est reliée à l'entrée de l'amplificateur, et une deuxième résistance reliée entre l'émetteur du troisième transistor et la troisième source de courant. La deuxième branche comprend un quatrième transistor ayant son émetteur relié au point de jonction de la deuxième résistance et de la troisième source de courant, son collecteur relié au point de jonction de la première résistance et du groupe de diodes en série, et sa base portée à un potentiel de référence Vréf.

Enfin, on prévoit que le courant de la troisième source de courant est choisi tel que pour une tension d'entrée Ve nulle le courant dans les diodes soit exactement la moitié du courant dans la première source de courant (dans le cas où les diodes ont même surface que l'émetteur du premier transistor).

Dans une réalisation particulière, le courant de la troisième source de courant est commandé par un circuit de régulation qui prend en compte les variations du potentiel haut auquel est reliée la première résistance et qui prend aussi en compte les incertitudes sur la connaissance de la valeur de la première résistance, car ces variations de potentiel et ces incertitudes affectent la valeur du courant dans les diodes.

D'autres caractéristiques et avantages de l'invention apparaîtront à la lecture de la description détaillée qui suit et qui est faite en référence aux dessins annexés dans lesquels :

- la figure 1 déjà décrite représente un amplificateur de type connu,
- la figure 2 représente un amplificateur modifié selon l'invention,
- la figure 3 représente un schéma détaillé d'un mode de réalisation de la source de courant SC3 de la figure 2.

Le schéma de la figure 2 comporte les mêmes références que celui de la figure 1 pour les éléments identiques, à savoir les transistors Q1, Q2, les sources de courant SC1, SC2, les diodes D1, D2, l'entrée E, la sortie S, et les bornes d'alimentation A et B. Pour ces éléments, le montage est exactement le même qu'à la figure 1.

La source de courant SC'1 de la figure 1 a été supprimée et remplacée par une résistance R1.

De plus a été rajouté un circuit de compensation qui comprend les éléments suivants : troisième transistor Q3, quatrième transistor Q4, deuxième résistance R2, et troisième source de courant SC3, le montage étant celui qui a été expliqué ci-dessus et qui apparaît clairement à la figure 2 : la première branche du circuit de compensation est constituée par Q3 et R2 en série, la base du transistor Q3 étant reliée à l'entrée E de l'amplificateur ; la deuxième branche est constituée par le transistor Q4 dont la base est à un potentiel de référence Vréf. La source de courant SC3 maintient à une valeur constante Ic la somme du courant I3 dans la première branche (R2, Q3) et du courant I4 dans la deuxième branche (Q4). Le potentiel Vréf est choisi suffisamment bas pour que le transistor Q3 reste conducteur dans toute la dynamique des tensions d'entrée Ve.

Par principe, l'amplificateur de la figure 2 comme celui de la figure 1 fournit une tension de sortie Vs = Ve seulement si le courant 2I de la source SC1 se partage également entre le transistor Q1 et les diodes D1 et D2.

Mais l'incertitude sur la valeur de la résistance R1 fait qu'on ne connait pas précisément le courant dans cette résistance. De plus, une variation de la tension d'entrée Ve modifie a priori le courant dans la résistance R1 donc dans les diodes D1, D2, et enfin une variation de potentiel d'alimentation Vcc modifie aussi le courant dans la résistance R1.

C'est le rôle du circuit de compensation (Q3, Q4, R2, SC3) de dériver une partie du courant circulant dans la résistance R1 dans une mesure telle que les variations de courant dans la résistance R1 dues essentiellement aux variations de la tension d'entrée Ve n'influent pas sur le courant dans les diodes D1 et D2 et qu'au contraire le courant dans ces diodes non seulement soit constant mais encore ait, malgré l'incertitude sur la valeur de la résistance R1, une valeur égale à I (dans l'hypothèse où la source SC1 a une valeur 2I et où les diodes D1 et D2 ont la même surface que l'émetteur du transistor Q1).

En supposant d'abord que le courant dans les diodes D1 et D2 est effectivement I, toute variation de tension d'entrée Ve tendra à induire une variation de courant dans le transistor Q1 d'où une variation en sens contraire du courant dans les diodes D1 et D2. Cette variation de courant dans les diodes D1 et D2 est compensée par le fait que la variation de tension d'entrée Ve induit aussi une variation du courant I3 dans le transistor Q3 et la résistance R2, donc une variation en sens contraire du courant I4 dans le transistor Q4 puisque la somme I3 + I4 est constante.

Dès lors il y a une variation du courant I4 soutiré de la résistance R1 qui est opposée à la variation de courant induite dans les diodes D1 et D2, ce qui tend à rétablir le courant dans les diodes à sa valeur initiale I. Cela suppose que la résistance R2 ait la même valeur que la résistance R1, ce que l'on sait bien faire dans la technologie des circuits intégrés.

Le courant dans les diodes D1 et D2 restant égal à I malgré les variations de tension d'entrée Ve, il en résulte alors que la tension de sortie Vs suit exactement la tension d'entrée Ve.

Pour cette explication on a du supposer qu'à l'origine (pour Ve = 0) le courant dans les diodes est bien égale à I ; ce serait vrai si on avait une tension Vcc bien stable et une résistance R1 de valeur bien connue égale à (Vcc-Vbe)/(I + I4) Vbe étant la chute de tension dans la diode D1 traversée par un courant I.

Mais en réalité Vcc n'est pas forcément stable et surtout R1 est très mal connue en valeur absolue et a peu de chances d'être exactement égale à (Vcc-Vbe)/(I + I4).

C'est pourquoi, au lieu que la source de courant SC3 fournisse un courant fixe calculé à l'avance d'une manière théorique, on prévoit qu'elle fournit un courant qui prend en compte les erreurs possibles sur les valeurs de Vcc et de R1.

Plus précisément, le courant Ic est asservi à une valeur telle que pour une tension d'entrée nulle le potentiel du point milieu entre les diodes D1 et D2 soit également nul.

Car alors, cela signifie que la diode D2 (donc D1 aussi) est bien parcourue par le même courant que le transistor Q1 ; ce courant est alors la moitié du courant de la source SC1 : c'est bien un courant de valeur I.

Le courant dans la résistance R1 est alors la somme du courant I et du courant Ic moins le courant circulant dans la résistance R2.

Pour cette explication on a du supposer qu'à l'origine (pour une tension d'entrée nulle Ve = 0), le courant dans les diodes est bien égal à I.

Or le courant dans la résistance R1 pour une tension d'entrée nulle est déterminé par la tension qui est présente à ses bornes. Cette tension est Vcc-Vbe où Vbe est la chute de tension aux bornes de la diode D1 traversée par le courant I.

Le courant au repos dans la résistance R1 (tension d'entrée Ve = 0) est alors Ir = (Vcc-Vbe)/R1.

Si on veut un courant I dans les diodes il faut donc que le courant dérivé au repos par le transistor Q4 soit Ir-I, c'est-à-dire ((Vcc-Vbe)/RI)-I.

Comme ce courant Ir-I est par ailleurs obligatoirement égal à la différence entre le courant Ic de la source SC3 et le courant circulant dans la résistance R2, et comme ce dernier est sensiblement égal à (Ve-Vréf)/R2 c'est-à-dire -Vréf/R2 lorsque Ve = 0, on doit en conclure que la valeur du courant constant Ic de la troisième source de courant SC3 est nécessairement

Ic = ((Vcc-Vbe)/R1) - I - Vréf/R2

(avec R1 = R2)

La valeur qu'il faut choisir pour Ic est donc théoriquement déterminée en fonction :

- de Vcc
- du courant de la première source de courant
- de Vréf
- de R1, R2
- de la chute de tension Vbe dans la diode D1 pour un courant I égal à la moitié du courant de la première source de courant.

En pratique cependant la valeur de R1 n'est pas connue avec assez de précision, et la valeur de Vcc peut varier.

C'est pourquoi on propose, dans une variante de réalisation représentée à la figue 3, de réaliser la source de courant SC3 sous la forme d'une source de courant commandée prenant en compte les incertitudes sur la valeur de R1 et les variations possibles de Vcc et même de Vréf.

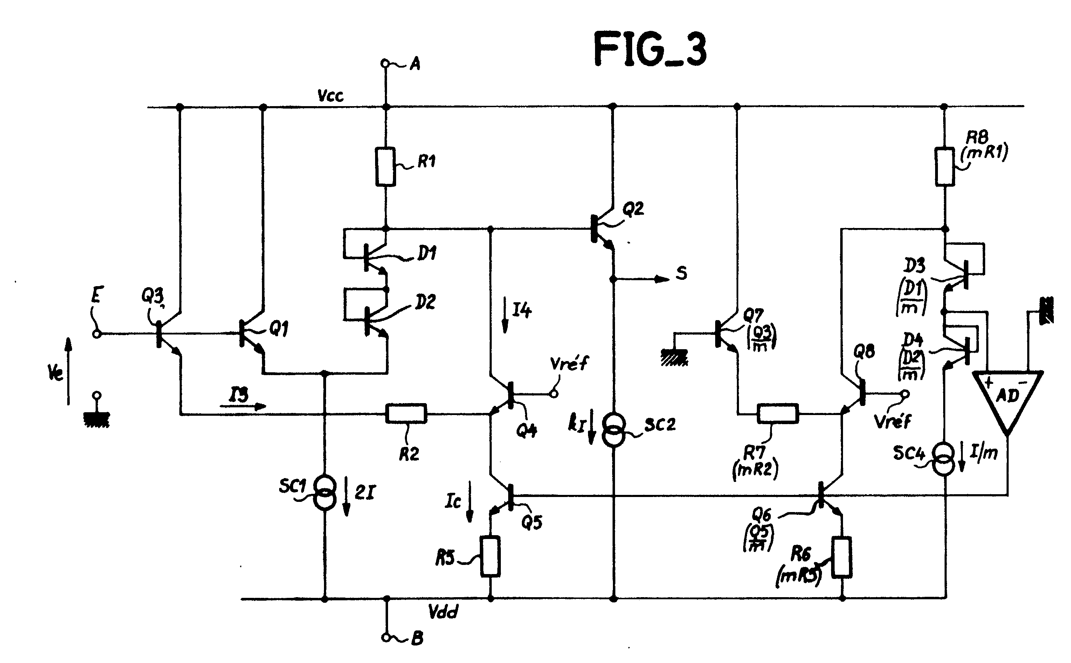

Sur la figure 3 on a reproduit les mêmes éléments que sur la figure 2, avec cette différence que la source de courant SC3 a été remplacée par un transistor Q5 en série éventuellement avec une résistance R5 reliée au potentiel bas Vdd, la base du transistor T5 étant commandée par un circuit de régulation regroupé dans la partie droite de la figure 3.

Le circuit de régulation comprend un transistor Q6 dans lequel on établit un courant I6 proportionnel à ((Vcc-Vbe)/R1) - I -Vréf/R2 ; le transistor Q5 sert alors seulement à recopier, éventuellement avec un coefficient multiplicateur, le courant Ic, grâce à un montage en miroir de courant.

Le transistor Q6 a donc sa base reliée à la base du transistor Q5 et son émetteur relié à une résistance R6 reliée par ailleurs comme la résistance R5 au potentiel bas Vdd. Le rapport entre les résistances R5 et R6 est inversement proportionnel au rapport entre les surfaces d'émetteur des transistors Q5 et Q6 ; dans la suite on supposera que ce rapport est égal à l'unité de sorte que le courant qui circule dans Q6 et R6 est égal à Ic comme celui qui circule dans Q5 et R5.

Le collecteur du transistor Q6 est relié à deux branches de circuit dont l'une comprend un transistor Q7 et une résistance R7 et l'autre comprend un transistor Q8.

Le transistor Q7 a son collecteur relié au potentiel haut Vcc, son émetteur relié à la résistance R7 et sa base reliée à la masse ; la résistance R7 est par ailleurs reliée au collecteur du transistor Q6.

Le transistor Q8 a son émetteur relié au collecteur du transistor Q6, sa base reliée au même potentiel Vréf que la base du transistor Q4, et son collecteur relié au point de jonction entre une résistance R8 et deux diodes D3 et D4 ; cette résistance R8 est connectée d'une part au même potentiel haut Vcc que la résistance R1 et d'autre part au groupe de deux diodes en série D3 et D4 polarisées en direct, exactement de la même manière que la résistance R1 est en série avec les diodes D1 et D2. De plus, le groupe de diodes D3 et D4 est relié à une source de courant constant SC4 reliée par ailleurs au potentiel bas Vdd de manière qu'un courant constant soit imposé dans les didoes D3 et D4. La valeur de ce courant est choisié égale à I dans l'hypothèse où le rapport de recopie des courants entre les transistors Q6 et Q5 est unitaire. Si ce rapport est égal à m, le courant choisi pour la source SC4 est I/m, la résistance R7 est égale à mR2, la résistance R8 à mR1, les surfaces d'émetteur des transistors Q7 et Q8 sont m fois plus faibles que celles des transistors Q3 et Q4 respectivement, et les surfaces des diodes D3 et D4 sont également m fois plus faibles que celles des diodes D1 et D2.

On rappelle que dans un circuit intégré on sait réaliser avec précision des rapports de résistances, des rapports de surfaces de transistors ou de diodes, et des rapports de valeurs de sources de courant, même si on ne sait pas obtenir des valeurs absolues précises pour ces quantités.

Enfin, pour terminer la description du schéma de la figure 3, un amplificateur différentiel AD assure la régulation du courant Ic de la manière suivante : une entrée inverseuse de l'amplificateur AD est reliée à la masse et l'autre au point milieu entre les diodes D3 et D4, la sortie de l'amplificateur AD commandant directement ou indirectement la base du transistor Q6 pour faire varier le courant dans le transistor Q6 dans un sens tendant à maintenir à zéro le potentiel du point de jonction entre les diodes D3 et D4.

Le circuit de régulation fonctionne de la manière suivante :

Comme l'amplificateur AD maintient le potentiel du point de jonction entre D3 et D4 à une valeur nulle, le potentiel au point de jonction entre R8 et D3 se maintient à une valeur Vbe qui est la même que la valeur de la chute de tension aux bornes de la diode D1 supposée parcourue par un courant I (car D3 a une surface m fois plus faible que D1 et est parcourue par un courant I/m).

Le courant dans la résistance R8 est donc $(Vcc-Vbe)/mR1$ (puisque $R8 = mR1$)

Le courant dans le transistor Q8 est $((Vcc-Vbe)/mR1) - I/m$ puisque c'est la différence entre le courant dans R8 et le courant dans les didoes D3, D4.

Le courant dans le transistor Q6 est la différence entre le courant dans le transistor Q8 et le courant dans la résistance R7. Ce dernier est sensiblement égal à $-Vréf/R7$ c'est-à-dire $-Vréf/mR2$, car la polarisation de base de Q7 est égale à zéro tandis que celle de Q8 est Vréf.

Le courant dans le transistor Q6 est donc $(Vcc-Vbe)/mR1-Im-Vréf/mR2$.

On voit qu'en le multipliant par un coefficient m, par recopie du courant entre le transistor Q6 et le transistor Q5, on obtient bien dans le transistor Q5 un courant Ic égal à $(Vcc-Vbe)/R1-I-Vréf/R2$ qui est justement le courant qui est nécessaire comme on l'a expliqué, pour imposer que les diodes D1 et D2 soient parcourus par un courant I lorsque la tension d'entrée Ve est nulle.

Grâce à ce circuit de régulation, on a donc établi un courant I dans les diodes D1 et D2 pour Ve = 0 indépendamment des variations ou dispersions de valeurs de Vcc et de R1. Lorsque Ve varie, le circuit de compensation selon l'invention maintient à la valeur I le courant dans les diodes D1 et D2.

**Revendications**

1. Amplificateur suiveur de tension, du type comprenant un étage d'entrée et un étage de sortie connectées entre une borne de tension haute (Vcc) et une borne de tension basse (Vdd), l'étage d'entrée comprenant une première source de courant (SC1) alimentant deux branches en parallèle dont l'une comprend un premier transistor bipolaire NPN (Q1) dont la base constitue l'entrée (E) de l'amplificateur, et l'autre comprend deux diodes (D1 et D2) parcourues par un courant constant, et l'étage de sortie comprend un déuxième transistor bipolaire NPN (Q2) qui est en série avec une autre source de courant (SC2) et dont la base est connectée à l'une des diodes, caractérisé en ce qu'il est prévu :
   - une première résistance (R1) en série avec les deux diodes dans la deuxième branche de l'étage d'entrée,
   - un circuit de compensation (Q3, Q4, R2, SC3) relié entre le point de jonction entre la première résistance et les diodes et la borne de tension basse et commandé par la tension à l'entrée (E) de l'amplificateur pour dériver audit point un courant variant en fonction de la tension d'entrée de l'amplificateur, la variation de ce courant compensant exactement les variations de courant qui seraient induites dans la résistance par les variations de la tension d'entrée en l'absence du circuit de compensation, de sorte que le courant dans les diodes reste constant malgré les variations de la tension d'entrée.

2. Amplificateur selon la revendication 1, caractérisé en ce que le circuit de compensation comprend :

- un troisième transistor (Q3) dont la base est reliée à l'entrée de l'amplificateur,
- un quartrième transistor (Q4) dont la base est à un potentiel de référence (Vréf),
- une deuxième résistance (R2) connectée entre les émetteurs des troisième et quatrième transistors,
- une troisième source de courant (SC3) connectée à l'émetteur du quatrième transistor,
- le collecteur du quatrième transistor étant relié au point de jonction entre la première résistance (R1) et les diodes (D1, D2).

3. Amplificateur selon la revendication 2, caractérisé en ce que la deuxième résistance à la même valeur que la première.

4. Amplificateur selon l'une des revendications 2 et 3, caractérisé en ce que la troisième source de courant établit un courant de valeur :

$$Ic = ((Vcc-Vbe)/R1) - I- Vréf/R2$$

où

- Vcc est un potentiel haut auquel est connectée la première résistance,
- Vbe est la chute de tension dans la diode connectée à la première résistance lorsque cette diode est parcourue par un courant I,
- I est le courant que l'on veut avoir dans les diodes lorsque la tension d'entrée de l'amplificateur est nulle,
- Vréf est le potentiel de référence appliqué à la base du quatrième transistor,
- R1 et R2 sont les valeurs des première et deuxième résistances.

5. Amplificateur selon la revendication 4, caractérisé en ce que la troisième source de courant est constituée par un cinquième transistor (Q5) recopiant un courant dans un sixième transistor (Q6), le courant dans le transistor Q6 étant établi à partir :
  - du potentiel Vcc
  - du potentiel Vréf
  - d'une source de courant de valeur proportionnelle à I
  - de résistances de valeurs proportionnelles à R1 et R2 de manière que le courant dans le transistor Q6 ait une valeur proportionnelle à :

$$((Vcc-Vbe)/R1) - I - Vréf/R2.$$

6. Amplificateur selon la revendication 5, caractérisé en ce que le sixième transistor (Q6) alimente en courant d'une part une branche contenant une troisième résistance (R7) alimentée sous une tension Vréf et d'autre part un transistor supplémentaire (Q8) parcouru par un courant qui est la différence entre le courant dans une quatrième résistance (R8) et le courant dans une diode alimentée par un courant constant, une tension Vcc-Vbe étant maintenue aux bornes de la quatrième résistance (R8) à l'aide d'un amplificateur différentiel agissant sur la base du sixième transistor.

**Claims**

1. A voltage follower amplifier, of the type comprising an input stage and an output stage connected between a high voltage connection (Vcc) and a low voltage connection (Vdd), the input stage comprising a first current source (SC1) loaded by two parallel branches, one of which comprises a first NPN bipolar transistor (Q1) with its base costituting the input (E) of the amplifier, and the other branch comprises two diodes (D1 and D2) flown through by a constant current, and the output stage comprises a second NPN bipolar transistor (Q2) which is in series with another current source (SC2) and the base of which is connected to one of the diodes, characterized in that the following elements are provided:
  - a first resistor (R1) in series with the two diodes in the second branch of the input stage,
  - a compensation circuit (Q3, Q4, R2, SC3) connected between the junction point between the first resistor and the diodes and the low voltage connection and controlled by the input voltage (E) of the amplifier to derive from said point a current varying as a function of the input voltage of the amplifier, the variation of this current exactly compensating the current variations which would be induced in the resistor by the variations of the input voltage in the absence of the compensation circuit, such that the current in the diodes remains constant in spite of the variations of the input voltage.

2. An amplifier as claimed in claim 1, wherein the compensation circuit comprises:
  - a third transistor (Q3), the base of which is connected to the input of the amplifier,
  - a fourth transistor (Q4), the base of which is at a reference voltage (Vref),

- a second resistor (R2) connected between the emitters of the third and fourth transistors,
- a third current source (SC3) connected to the emitter of the fourth transistor,
- the collector of the fourth transistor being connected to the junction point between the first resistor (R1) and the diodes (D1, D2).

3. An amplifier as claimed in claim 2, wherein the second resistor has the same value as the first one.

4. An amplifier as claimed in one of claim 2 or 3, wherein the third current source establishes a current having a value of:

$$Ic = ((Vcc-Vbe)/R1)-I-Vref/R2$$

where

- Vcc is a high voltage to which is connected the first resistor,
- Vbe is the voltage across the diode connected to the first resistor when this diode is flown through by a current I,
- I is the current which is desired in the diodes when the input voltage of the amplifier is null,
- Vref is the reference voltage applied to the base of the fourth transistor,
- R1 and R2 are the values of the first and second resistors.

5. An amplifier as claimed in claim 4, wherein the third current source is comprised of a fifth transistor (Q5) mirroring a current flowing through a sixth transistor (Q6), the current in transistor Q6 being established by:
   • the voltage Vcc
   • the voltage Vref
   • a current source providing a current of a value proportional to I
   • resistors of values proportional to R1 and R2 such that the current in transistor Q6 has a value proportional to:

$$((Vcc-Vbe)/R1)-I-Vref/R2.$$

6. An amplifier as claimed in claim 5, wherein the sixth transistor (Q6) provides a current, on the one hand to a branch comprising a third resistor (R7) supplied by a voltage Vref, and on the other hand to an additional transistor (Q8) flown through by a current which is the difference between the current in a fourth resistor (R8) and the current in a diode supplied by a constant current, the voltage Vcc-Vbe being maintained across the fourth resistor (R8) by means of a differential amplifier acting upon the base of the sixth transistor.

**Patentansprüche**

1. Spannungsfolgeverstärker mit einer Eingangsstufe und einer Ausgangsstufe, die an eine Quelle hoher Spannung (Vcc) bzw. eine Quelle niedriger Spannung (Vdd) angeschlossen sind, wobei die Eingangsstufe eine erste Stromquelle (SC1) aufweist, die zwei parallele Schaltungszweige versorgt, von denen der erste einen ersten bipolaren Transistor NPN (Q1), dessen Basis den Eingang (E) des Verstärkers bildet, und der zweite zwei Dioden (D1 und D2) aufweist, die von einem konstanten Strom durchflossen werden, und wobei die Ausgangsstufe einen zweiten bipolaren Transistor NPN (Q2) aufweist, der in Serie mit einer weiteren Stromquelle (SC2) liegt und dessen Basis mit einer der Dioden verbunden ist, dadurch gekennzeichnet, daß folgende Schaltungsmerkmale vorgesehen sind:

   - ein erster Widerstand (R1) in Serie mit den zwei Dioden im zweiten Schaltungszweig der Eingangsstufe,
   - eine Kompensationsschaltung (Q3, Q4, R2, SC3), die zwischen dem Verbindungspunkt zwischen erstem Widerstand und den Dioden und der Quelle mit niedriger Spannung geschaltet ist und von der Spannung am Eingang (E) des Verstärkers gesteuert wird, um an dem genannten Punkt einen Strom abzuleiten, der als Funktion der Eingangsspannung des Verstärkers variiert, wobei dieser Strom diejenigen Stromänderungen kompensiert, die in dem Widerstand durch die Änderung der Eingangsspannung in Abwesenheit der Kompensationsschaltung erzeugt würden, derart, daß der Strom in den Dioden trotz der Änderung der Eingangsspannung konstant bleibt.

2. Verstärker nach Anspruch 1, dadurch gekennzeichnet, daß die Kompensationsschaltung aufweist:

   - einen dritten Transistor (Q3), dessen Basis mit dem Eingang des Verstärkers verbunden ist,
   - einen vierten Transistor (Q4), dessen Basis an einem Referenzpotential (Vref) liegt,
   - einen zweiten Widerstand, der zwischen die Emitter des dritten und vierten Transistors geschaltet ist,

- eine dritte Stromquelle (SC3), die mit dem Emitter des vierten Transistors verbunden ist, wobei
- der Kollektor des vierten Transistors mit dem Verbindungspunkt zwischen dem ersten Widerstand (R1) und den Dioden (D1, D2) verbunden ist.

3. Verstärker nach Anspruch 2, dadurch gekennzeichnet, daß der zweite Widerstand den gleichen Wert wie der erste hat.

4. Verstärker nach einem der Ansprüche 2 und 3, dadurch gekennzeichnet, daß die dritte Stromquelle einen Strom liefert mit dem Wert:

Ic = ((Vcc-Vbe)/R1)-I-Vref/R2

wobei

- Vcc ein hohes Potential ist, mit dem der erste Widerstand verbunden ist,
- Vbe der Spannungsabfall in der Diode ist, die mit dem ersten Widerstand verbunden ist, solange die Eingangsspannung des Verstärkers Null ist,
- Vref das Referenzpotential ist, das an der Basis des vierten Transistors angelegt wird, und
- R1 und R2 die Widerstandswerte des ersten bzw. zweiten Widerstandes sind.

5. Verstärker nach Anspruch 4, dadurch gekennzeichnet,
daß die dritte Stromquelle durch einen fünften Transistor (Q5) gebildet wird, der den gleichen Strom erzeugt, der in einem sechsten Transistor (Q6) fließt, wobei der Strom in dem Transistor (Q6) bestimmt wird durch:

* das Potential Vcc
* das Potential Vref
* eine Stromquelle mit einem Stromwert proportional zu I
* Widerstände mit Werten proportional zu R1 und R2 derart, daß der Strom in dem Transistor Q6 einen Wert aufweist proportional zu

((Vcc-Vbe)/R1)-I-Vref/R2.

6. Verstärker nach Anspruch 5, dadurch gekennzeichnet, daß der sechste Transistor (Q6) einerseits einen an einer Spannung Vref liegenden Schaltungszweig mit einem dritten Widerstand (R7) und andererseits einen zusätzlichen Transistor (Q8) mit Strom versorgt, der von einem Strom durchflossen wird, der die Differenz zwischen dem Strom in einem vierten Widerstand (R8) und dem Strom in einer mit einem konstanten Strom versorgten Diode ist, wobei eine Spannung Vcc-Vbe an den Anschlüssen des vierten Widerstandes (R8) mit Hilfe eines Differenzverstärkers aufrechterhalten wird, der auf die Basis des sechsten Transistors wirkt.

FIG_1

FIG_2

FIG_3

EP 0 242 304 B1